Europäisches Patentamt

European Patent Office

Office européen des brevets

(11) Publication number: **0 407 202 A2**

# EUROPEAN PATENT APPLICATION

(21) Application number: **90307377.3**

(22) Date of filing: **05.07.90**

(51) Int. Cl.⁵: **H01L 21/285, H01L 21/3205**

(30) Priority: **06.07.89 JP 175105/89**

(43) Date of publication of application:
**09.01.91 Bulletin 91/02**

(84) Designated Contracting States:
**DE FR GB**

(71) Applicant: **SONY CORPORATION**
**7-35 Kitashinagawa 6-Chome Shinagawa-ku**
**Tokyo 141(JP)**

(72) Inventor: **Sumi, Hirofumi, Sony Corporation**
**7-35, Kitashinagawa 6-chome, Shinagawa-ku**
**Tokyo(JP)**
Inventor: **Nishihara, Toshiyuki,Sony**
**Corporation**
**7-35, Kitashinagawa 6-chome, Shinagawa-ku**
**Tokyo(JP)**

(74) Representative: **Cotter, Ivan John et al**
**D. YOUNG & CO. 10 Staple InnInn**
**London WC1V 7RD(GB)**

(54) **Manufacturing semiconductor devices.**

(57) In manufacturing a semiconductor device, a silicon compound film (3) having a thickness of less than 50 angstroms is formed on a silicon substrate (1). Next, a metal film (4) is formed on the silicon compound film (3). Then, a two stage annealing process, which includes a low temperature annealing followed by a high temperature annealing, is performed. A metal silicide film (6) may be formed with high selectivity on the silicon substrate (1) by forming a silicide layer (5) on the silicon compound.

FIG. 2

## MANUFACTURING SEMICONDUCTOR DEVICES

This invention relates to the manufacture of semiconductor devices.

In so-called "salicide" (self aligned silicide) technology, which can be employed in the manufacture of semiconductor devices, a metal silicide film is formed on a diffused layer and a gate electrode to decrease the sheet resistance thereof. A method of forming a silicide layer on a diffused layer is disclosed, for example, in Japanese Patent Application Publication No. JP-A-63-8U06U.

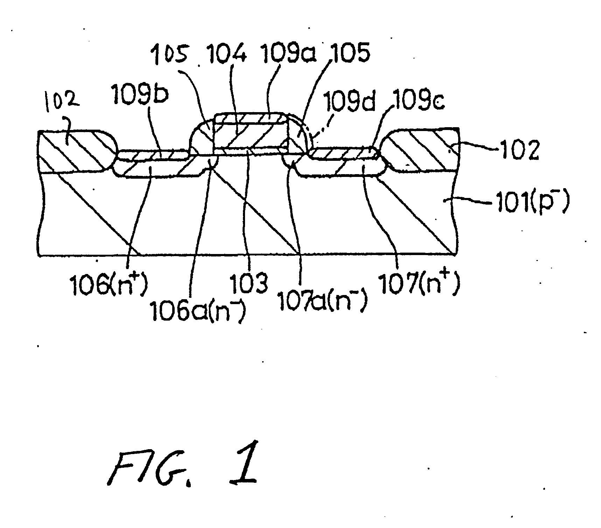

A previously proposed method of semiconductor manufacture utilising SALICIDE technology will now be described with reference to Figure 1 of the accompanying drawings. As shown in Figure 1, a field insulating film 102, such as a silicon oxide (SiO$_2$) film, is selectively formed on portions of a P-type silicon substrate 101 for effecting isolation between various elements. Then, a gate insulating film 103, such as a thermally grown SiO$_2$ film, is formed on the surface of an active region between the field insulating portions 102. Next, a polycrystalline silicon film is formed on the surface of the gate insulating film 103 by a chemical vapour deposition (CVD) process, after which impurities such as phosphorus (P) are doped into the polycrystalline film to decrease the resistance thereof. The polycrystalline film is then etched in a desired pattern to form a gate electrode 104 atop the insulating film 103. Conventionally, N-type impurities, for example phosphorus, are then implanted at low concentration into the silicon substrate 101, with the gate electrode 104 acting as a mask, after which a further SiO$_2$ film is deposited over the gate electrode 104 and the gate insulating film 103. This further SiO$_2$ film is subjected to anisotropic etching vertically and horizontally relative to the substrate 101 by a reactive ion etching (RIE) process to form side wall spacers 105 on the sides of the gate electrode 104. Then, N-type impurities such as arsenic (As) are implanted at high concentration into the silicon substrate 101 with the side wall spacers 105 acting as a mask, annealing then being performed to electrically activate the implanted impurities.

The above step forms an N + type source region 106 and a drain region 107 which are self-aligned relative to the gate electrode 104. An N-channel MOSFET (metal oxide semiconductor field effect transistor) is thereby formed, the MOSFET comprising the gate electrode 104, the source region 106 and the drain region 107. In such a construction, the source and drain regions 106 and 107 will have lightly doped N-type regions 106a and 107a at positions under the side wall spacers 105. Thus, the N-channel MOSFET has a so-called LDD (Lightly Doped Drain) structure in which the lightly doped region 107a moderates the electric field near to the drain region 107.

After this, a titanium film is formed over the entire surfaces of the above-mentioned elements by a sputtering process.

An annealing process is then performed at 600°C in an atmosphere of argon (Ar) to react the Ti film where it contacts the gate electrode 104, the source region 106 and the drain region 107. This process converts surface portions of the gate electrode 104, the source region 106 and the drain region 107 into a silicide layer. As shown in Figure 1, titanium silicide (TiSi) films 109a, 109b and 109c are formed on the surfaces of the gate electrode 104, the source region 106 and the drain region 107, respectively. Finally, the unreacted Ti film is removed using a wet etching process.

In MOS LSIs (large scale integrated circuits) manufactured according to the above method, the TiSi films 109a, 109b and 109c can decrease the sheet resistances of the gate electrode 104, the source region 106 and the drain region 107.

However, the silicide forming technique described above has a disadvantage in that silicon atoms may 'ooze into' the side wall spacers 105 through the silicon substrate 101, so that an undesired TiSi film 109d (shown by a broken line in Figure 1) is formed on the side wall spacer 105, the film not being removable by post etching. This results in an electrical short circuit between the gate electrode 104 and the drain region 107, which phenomenon reduces production efficiency and is responsible for a high number of defective LSIs (low process yield).

According to a first aspect of the invention there is provided a method of manufacturing a semiconductor device, the method comprising the steps of:

forming a film of a silicon compound on a silicon substrate; the silicon compound film having a thickness of less than 50 angstroms;

forming a metal film on the silicon compound film; and

annealing the substrate, the silicon film and the metal film at a temperature sufficiently high to form a silicide layer on the substrate.

According to a second aspect of the invention there is provided a method of manufacturing a semiconductor device, the method comprising the steps of:

selectively forming a film of a silicon compound on areas of a silicon substrate;

forming a second film of the silicon compound over the selectively formed film and substrate, the second film having a thickness of less than 50 angstroms;

forming a metal film on the second film;

performing a first annealing on the substrate, the silicon film and the metal film;

performing a second annealing on the substrate, the silicon film and the metal film, the second annealing being performed at a higher temperature than the first annealing for forming a silicide layer on the substrate.

According to a third aspect of the invention there is provided a semiconductor device comprising:

a silicon substrate;

a film of a silicon compound selectively formed on areas of the substrate;

a silicide layer selectively formed between the selectively formed areas of said film, the silicide layer having been formed by annealing a silicon compound layer having a thickness of less than 50 angstroms and a metal film, and the silicide layer having a sheet resistance substantially equal to 4 ohms per square.

A preferred embodiment of the invention described in detail below can be used to overcome or at least alleviate the deficiencies of the previous proposal. Thus, the preferred embodiment provides a method of manufacturing a semiconductor device in which a low resistance value metal silicide film may be selectively formed on a predetermined portion of a silicon substrate, and which has high reliability.

The invention will now be further described, by way of illustrative and non-limiting example, with reference to the accompanying drawings, in which:

Figure 1 is a cross sectional view of a previously proposed semiconductor device;

Figure 2A to 2C are progressive cross-sectional views showing the construction of a semiconductor device by a method embodying the invention;

Figure 3 is a cross-sectional view of a semiconductor device embodying the invention;

Figure 4 is a graph showing distribution of elements in a case in which a 100 angstrom film is used; and

Figure 5 is a graph showing distribution of elements in a case in which a 50 angstrom film is used.

A preferred method embodying the invention for manufacturing semiconductor devices will now be described in detail.

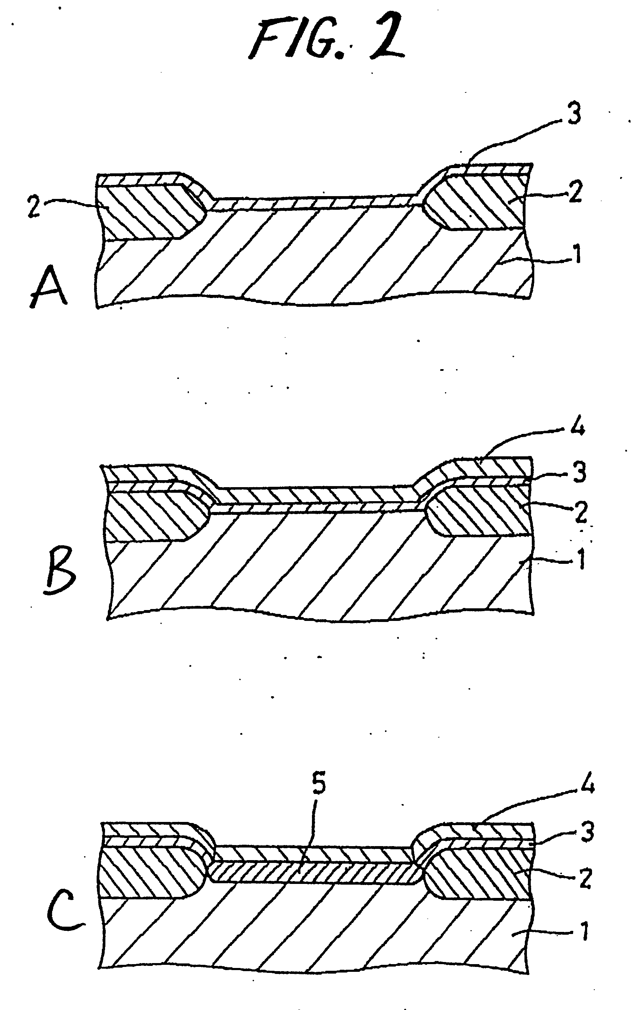

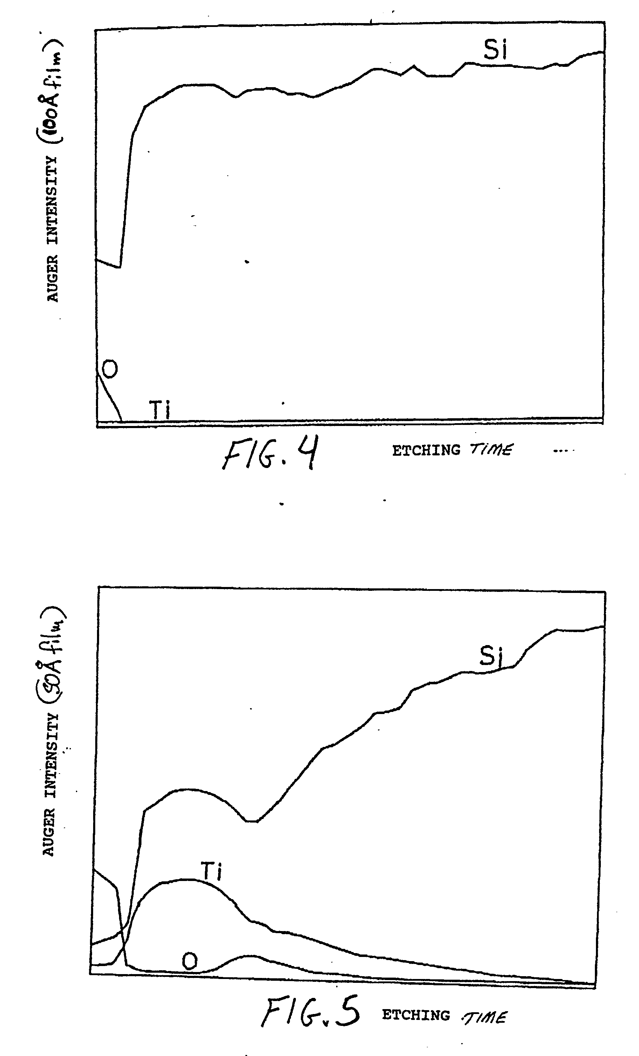

Figure 2A shows a silicon substrate 1 on which a $SiO_2$ field insulating film 2 has been selectively formed. Another $SiO_2$ film 3, having a thickness of less than 50 angstroms, is then formed over the exposed surface of the silicon substrate 1 and the field insulating film 2. This film promotes reaction with an overlaying titanium layer. However, as can be seen from Figure 4, if the $SiO_2$ film 3 is formed so as to be thicker than 50 angstroms, for example 100 angstroms, diffusion will not occur sufficiently during a subsequent annealing and etching process and the oxygen and titanium distribution throughout a $TiSi_2$ barrier layer thereby formed will be insufficient. On the other hand, referring to Figure 5, using a film with a thickness of 50 angstroms or less promotes diffusion and improves oxygen distribution and the titanium content of the $TiSi_2$ barrier layer thereby formed, improving barrier resistance to spikes from, aluminium, for example. Thus, according to the present method, the $SiO_2$ film 3 is formed to have a thickness of less than 50 angstroms, at which thickness sufficient diffusion will occur.

As mentioned above and is shown in Figure 2B, a titanium (Ti) film 4, having a thickness of 400 angstroms, is formed over the entire surface of the previously applied $SiO_2$ film 3 using, for example, a sputtering process.

Then, low temperature lamp annealing (rapid annealing) is performed at a temperature of 600°C. In a low temperature annealing process, a silicon compound reacts with a metal. The present low temperature annealing process is for forming a titanium silicide film 5 as shown in Figure 2C. The titanium silicide film 5 comprises $Ti_5Si_3$ and $TiSi$, and the titanium film 4 is oxidised into $TiO_2$ against the titanium silicide film 5. The remaining unreacted titanium film in and the $TiO_2$ is then removed by way of a wet etching process using aqueous ammonia or the like.

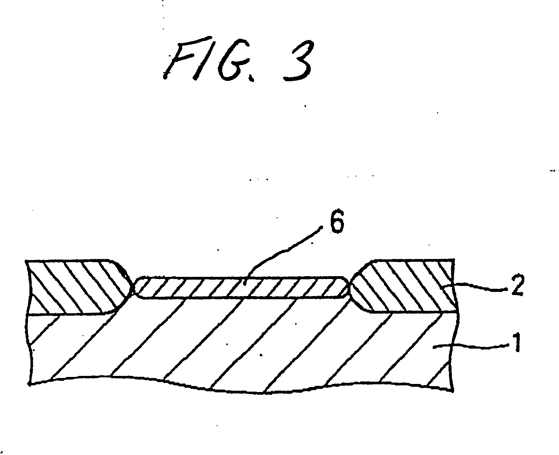

Next, the titanium silicide film 5 is converted into a $TiSi_2$ film 6 (Figure 3) by performing a second annealing (high temperature annealing) at 900°C. If the high temperature annealing is carried out a lower temperature, for example 800°C, the $TiSi_2$ that is formed has a high resistance value, substantially equal to 3 ohms per square, because of oxygen remaining in the $TiSi_2$ film 6. Thus, according to the preferred method, the second annealing is carried out at substantially 900°C, which can degas the remaining oxygen in the $TiSi_2$ film 6, thus giving the film a lower resistance value of 4 ohms per square.

Thus, the semiconductor device formed by the present method, which device is shown in Figure 3, may be formed so as to have a structure significantly simpler than conventional devices, whereby manufacturing reliability is improved.

Additionally, according to the present method, efficient degassing of oxygen is carried out in the silicide layer, thereby providing a semiconductor device with a low resistance value. The silicide layer of low resistance value can effectively improve the characteristics of a transistor device.

As described clearly above, the preferred semiconductor manufacturing method embodying the invention can effectively form a silicide layer with high selectivity, and with no rising, allowing formation of transistors with decreased leakage current characteristics.

Further, while the above semiconductor device is a transistor, methods embodying the invention may be readily applied to the manufacture of other semiconductor devices including various MOS LSIs, bipolar LSIs and bipolar CMOS LSIs.

While the invention has been specifically disclosed above, by way of example, in terms of a preferred embodiment, in order to facilitate better understanding thereof, the invention can of course be embodied in various other ways. For example, although the low temperature annealing is carried out at 600°C in the above embodiment, it is possible to select the low temperature annealing temperature to lie in a range of from 600°C to 700°C. Likewise, the high temperature annealing may alternatively be performed at temperatures in a range of from 800° to 1000°C, depending on the characteristics desired.

## Claims

1. A method of manufacturing a semiconductor device, the method comprising the steps of:
forming a film (3) of a silicon compound on a silicon substrate (1), the silicon compound film (3) having a thickness of less than 50 angstroms;
forming a metal film (4) on the silicon compound film (3); and annealing the substrate (1), the silicon film (3) and the metal film (4) at a temperature sufficiently high to form a silicide layer (6) on the substrate.

2. A method according to claim 1, wherein, after the annealing step, the semiconductor device is subjected to wet etching.

3. A method according to claim 1 or claim 2, wherein the annealing step comprises a first substantially low temperature annealing and a second substantially high temperature annealing, said first and second annealings forming the silicide layer (6) on the silicon substrate (1).

4. A method of manufacturing a semiconductor device, the method comprising the steps of:
selectively forming a film (2) of a silicon compound on areas of a silicon substrate (1);
forming a second film (3) of the silicon compound over the selectively formed film (2) and substrate (1), the second film (3) having a thickness of less than 50 angstroms;
forming a metal film (4) on the second film (3);
performing a first annealing on the substrate (1), the silicon film (3) and the metal film (4);

performing a second annealing on the substrate (1), the silicon film (3) and the metal film (in), the second annealing being performed at a higher temperature than the first annealing for forming a silicide layer (6) on the substrate (1).

5. A method according to claim in, wherein, after the second annealing, the semiconductor device is subjected to etching.

6. A method according to claim 5, wherein the etching is wet etching.

7. A method according to any one of claims 3 to 6, wherein the first annealing is carried out at 600°C.

8. A method according to any one of claims 3 to 7, wherein the second annealing is carried out at 900°C.

9. A method according to any one of claims 3 to 6, wherein the first annealing is carried out at a temperature within a range of 600°C to 700°C.

10. A method according to any one of claims 3 to 7, wherein the second annealing is carried out at a temperature within a range of 800°C to 1000°C.

11. A method according to any one of the preceding claims, wherein the silicon compound is $SiO_2$.

12. A method according to any one of the preceding claims, wherein the metal film (4) is a titanium film.

13. A method according to claim 12, wherein the titanium film (4) is formed with a thickness of 400 angstroms.

14. A method according to any one of the preceding claims, wherein the silicide layer (6) has a resistance value substantially equal to 4 ohms per square.

15. A semiconductor device comprising:
a silicon substrate (1);
a film (2) of a silicon compound selectively formed on areas of the substrate (1);
a silicide layer (6) selectively formed between the selectively formed areas of said film (2), the silicide layer (6) having been formed by annealing a silicon compound layer (3) having a thickness of less than 50 angstroms and a metal film (4), and the silicide layer (6) having a sheet resistance substantially equal to 4 ohms per square.

16. A device according to claim 15, wherein the metal film (4) is of titanium.

17. A device according to claim 16, wherein the titanium film was formed with a thickness of 400 angstroms.

18. A device according to claim 15, claim 16 or claim 17, wherein the silicide layer (6) was formed by two annealings.

19. A device according to claim 18, wherein the silicide layer (6) was annealed a first time at 600°C and a second time at 900°C.

20. A device according to any one of claims 15 to 19, wherein the silicide layer (6) has been subjected to etching.

21. A device according to claim 20, wherein the etching was wet etching.

FIG. 1

# FIG. 2

FIG. 3

FIG. 4

FIG. 5